(19) Europäisches Patentamt
European Patent Office
Office européen des brevets

(11) **EP 3 905 550 A1**

(12) **EUROPEAN PATENT APPLICATION**
published in accordance with Art. 153(4) EPC

(43) Date of publication:
**03.11.2021 Bulletin 2021/44**

(21) Application number: **19914402.3**

(22) Date of filing: **04.02.2019**

(51) Int Cl.:
**H04B 10/50** (2013.01)    **H01S 5/042** (2006.01)

(86) International application number:
**PCT/JP2019/003856**

(87) International publication number:
**WO 2020/161769 (13.08.2020 Gazette 2020/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **MITSUBISHI ELECTRIC CORPORATION**
**Chiyoda-ku**
**Tokyo 100-8310 (JP)**

(72) Inventors:
• **KOBAYASHI, Ryota**
**Tokyo 100-8310 (JP)**
• **SASAKI, Yuichi**
**Tokyo 100-8310 (JP)**
• **MIYAZAKI, Chiharu**
**Tokyo 100-8310 (JP)**

(74) Representative: **Pfenning, Meinig & Partner mbB**
**Patent- und Rechtsanwälte**
**An der Frauenkirche 20**
**01067 Dresden (DE)**

(54) **LASER DIODE DRIVE CIRCUIT AND COMMUNICATION DEVICE**

(57)    A laser diode drive circuit (2) includes: a laser diode (11); a differential line (12) including a first signal line (12a) having a first end connected with an anode terminal (11a) of the laser diode (11) and a second signal line (12b) having a first end connected with a cathode terminal (11b) of the laser diode (11); first power supply wiring (14a) having a first end connected with a positive side terminal (13a) of a direct current power supply (13) and a second end connected with the anode terminal (11a); second power supply wiring (14b) having a first end connected with a negative side terminal (13b) of the direct current power supply (13) and a second end connected with the cathode terminal (11b); a first capacitor (16a) inserted in the first signal line (12a); and a second capacitor (16b) inserted in the second signal line (12b). In the laser diode drive circuit (2), at least one of the first capacitor (16a) and the second capacitor (16b) is a variable capacitor.

FIG. 8

EP 3 905 550 A1

**Description**

**TECHNICAL FIELD**

The present invention relates to a laser diode drive circuit including a laser diode and a communication device.

**BACKGROUND ART**

Patent Literature 1 below discloses an optical transmitter including a semiconductor laser drive circuit for supplying a high-frequency modulation current based on a data signal between an anode terminal and a cathode terminal of a semiconductor laser via a differential line.
The semiconductor laser described in Patent Literature 1 outputs modulated laser light on the basis of a modulation current output from the semiconductor laser drive circuit.

**CITATION LIST**

**PATENT LITERATURE**

Patent Literature 1: JP 2005-252783 A

**SUMMARY OF INVENTION**

**TECHNICAL PROBLEM**

The semiconductor laser of the optical transmitter disclosed in Patent Literature 1 cannot output modulated laser light unless the semiconductor laser is supplied with power. Therefore, it is necessary in the semiconductor laser that the anode terminal be connected with a positive side terminal of a DC power supply via first power supply wiring and that the cathode terminal be connected with a negative side terminal of the DC power supply via second power supply wiring.
In a case where the optical transmitter includes the first and second power supply wiring and a differential line, parasitic capacitance is formed between the first power supply wiring and the differential line (hereinafter referred to as the "first parasitic capacitance"), and parasitic capacitance is formed between the second power supply wiring and the differential line (hereinafter referred to as the "second parasitic capacitance").
When the first and second parasitic capacitance are formed, noise is induced to the differential line from the first and second power supply wiring via a portion forming the first parasitic capacitance or a portion forming the second parasitic capacitance. At this point, in a case where the first parasitic capacitance and the second parasitic capacitance are different, the potential difference between the anode terminal and the cathode terminal of the semiconductor laser fluctuates due to the noise induced to the differential line. There are disadvantages that, when the potential difference between the anode terminal and the cathode terminal fluctuates due to noise, the correspondence relationship between the modulation current and the modulated laser light is lost and that the laser diode may erroneously emit light or erroneously go off.
The present invention has been made to solve the above-mentioned disadvantages, and it is an object of the present invention to obtain a laser diode drive circuit and a communication device each capable of preventing both of erroneous emission of light and erroneous extinction of light of a laser diode even when noise is induced to a differential line from power supply wiring via a portion forming parasitic capacitance.

**SOLUTION TO PROBLEM**

A laser diode drive circuit according to the present invention includes: a laser diode; a differential line including a first signal line having a first end connected with an anode terminal of the laser diode and a second signal line having a first end connected with a cathode terminal of the laser diode; first power supply wiring having a first end connected with a positive side terminal of a direct current power supply and a second end connected with the anode terminal; second power supply wiring having a first end connected with a negative side terminal of the direct current power supply and a second end connected with the cathode terminal; a first capacitor inserted in the first signal line; and a second capacitor inserted in the second signal line. At least one of the first capacitor and the second capacitor is a variable capacitor.

**ADVANTAGEOUS EFFECTS OF INVENTION**

According to the present invention, the laser diode drive circuit is configured so that at least one of the first capacitor and the second capacitor is a variable capacitor. Therefore, a laser diode drive circuit according to the present invention is capable of preventing both of erroneous emission of light and erroneous extinction of light of a laser diode even when noise is induced to a differential line from first and second power supply wiring via portions forming parasitic capacitance.

**BRIEF DESCRIPTION OF DRAWINGS**

FIG. 1 is a configuration diagram illustrating a communication device including a laser diode drive circuit 2 according to a first embodiment.

FIG. 2 is a configuration diagram illustrating the laser diode drive circuit 2 according to the first embodiment.

FIG. 3 is an explanatory diagram illustrating paths of noise currents $I_1$ to $I_4$ flowing in a differential line 12.

FIG. 4 is a diagram illustrating the pattern of a first layer 50a of a substrate 50 on which the laser diode drive circuit 2 illustrated in FIG. 2 is mounted.

FIG. 5 is a diagram illustrating the pattern of a second layer 50b of the substrate 50 on which the laser diode drive circuit 2 illustrated in FIG. 2 is mounted.

FIG. 6 is a diagram illustrating the arrangement relationship between a DC power supply 13 provided outside the substrate 50 and portions of first power supply wiring 14a and second power supply wiring 14b that are wired outside the substrate 50.

FIG. 7 is a cross-sectional view taken along line $A_1$ - $A_2$ of the laser diode drive circuit 2 illustrated in FIGS. 4 and 5.

FIG. 8 is a configuration diagram illustrating another laser diode drive circuit 2 according to the first embodiment.

FIG. 9 is a configuration diagram illustrating another laser diode drive circuit 2 according to the first embodiment.

FIG. 10 is a configuration diagram illustrating another laser diode drive circuit 2 according to the first embodiment.

FIG. 11 is a diagram illustrating the pattern of a first layer 50a of a substrate 50 on which the laser diode drive circuit 2 illustrated in FIG. 10 is mounted.

FIG. 12 is a configuration diagram illustrating a laser diode drive circuit 2 according to a second embodiment.

FIG. 13 is a configuration diagram illustrating another laser diode drive circuit 2 according to the second embodiment.

FIG. 14 is a configuration diagram illustrating another laser diode drive circuit 2 according to the second embodiment.

FIG. 15 is a configuration diagram illustrating another laser diode drive circuit 2 according to the second embodiment.

**DESCRIPTION OF EMBODIMENTS**

In order to describe the present invention further in detail, embodiments for carrying out the invention will be described below by referring to the accompanying drawings.

First Embodiment

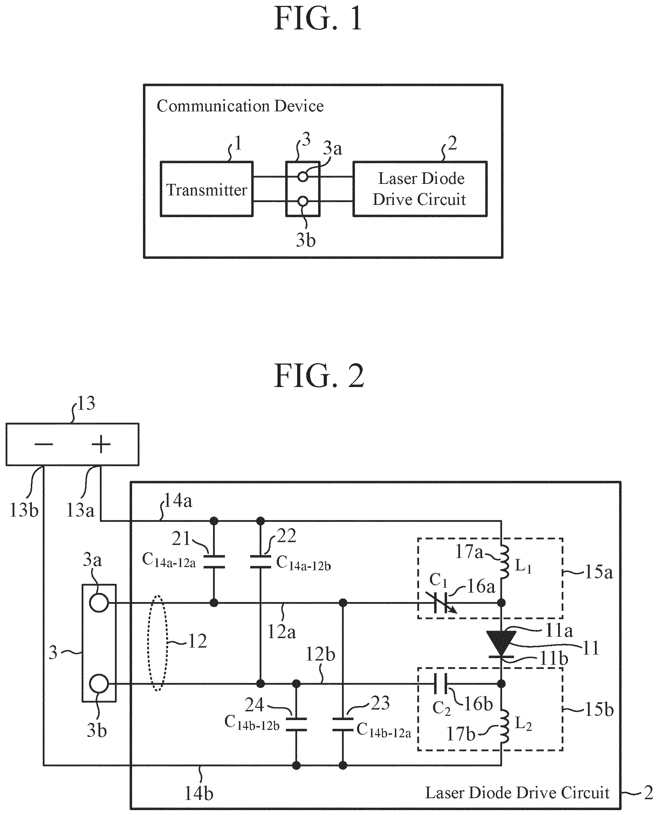

FIG. 1 is a configuration diagram illustrating a communication device including a laser diode drive circuit 2 according to a first embodiment.

FIG. 2 is a configuration diagram illustrating the laser diode drive circuit 2 according to the first embodiment.

In FIGS. 1 and 2, the communication device includes a transmitter 1 and the laser diode drive circuit 2.

The transmitter 1 outputs a differential high-frequency signal based on a data signal to the laser diode drive circuit 2 via a differential input and output terminal 3.

The communication device illustrated in FIG. 1 includes the transmitter 1. However, this is merely an example, and the communication device illustrated in FIG. 1 may include a receiver instead of the transmitter 1. However, in a case where the communication device illustrated in FIG. 1 includes a receiver instead of the transmitter 1, the laser diode drive circuit 2 includes a light-receiving element for converting light into an electric signal, in place of a laser diode 11 (see FIG. 2) described later.

The laser diode drive circuit 2 is connected with the transmitter 1 via the differential input and output terminal 3.

The laser diode drive circuit 2 includes the laser diode 11 that emits light on the basis of a differential high-frequency signal output from the transmitter 1.

The differential input and output terminal 3 includes a first input and output terminal 3a and a second input and output terminal 3b.

In the communication device illustrated in FIG. 1, the differential input and output terminal 3 is provided outside the laser diode drive circuit 2. However, this is merely an example, and the differential input and output terminal 3 may be included inside the laser diode drive circuit 2.

The laser diode 11 includes an anode terminal 11a and a cathode terminal 11b.

The anode terminal 11a is connected with the first input and output terminal 3a via a first signal line 12a. The cathode terminal 11b is connected with the second input and output terminal 3b via a second signal line 12b.

The laser diode 11 emits light on the basis of a differential high-frequency signal output from the transmitter 1.

A differential line 12 includes the first signal line 12a and the second signal line 12b.

The first signal line 12a has one end connected with the anode terminal 11a of the laser diode 11 and the other end connected with the first input and output terminal 3a.

The first signal line 12a transmits the high-frequency signal of the positive electrode side of the differential high-frequency signal output from the transmitter 1 to the anode terminal 11a of the laser diode 11.

The second signal line 12b has one end connected with the cathode terminal 11b of the laser diode 11 and the other end connected with the second input and output terminal 3b.

The second signal line 12b transmits the high-frequency signal of the negative electrode side of the differential high-frequency signal output from the transmitter 1 to the cathode terminal 11b of the laser diode 11.

A DC power supply 13 supplies DC power to the laser diode 11. The DC power supply 13 has a positive side terminal 13a and a negative side terminal 13b.

First power supply wiring 14a has one end connected with the positive side terminal 13a of the DC power supply 13 and the other end connected with the anode terminal 11a of the laser diode 11.

Second power supply wiring 14b has one end connected with the negative side terminal 13b of the DC power supply 13 and the other end connected with the cathode terminal 11b of the laser diode 11.

In the laser diode drive circuit 2 illustrated in FIG. 2, the DC power supply 13 is provided outside the laser diode drive circuit 2. However, this is merely an example, and the DC power supply 13 may be included inside the laser diode drive circuit 2.

A bias tee 15a includes a first capacitor 16a and a first inductor 17a and is connected with the anode terminal 11a of the laser diode 11.

The bias tee 15a combines the high-frequency signal of the positive electrode side transmitted by the first signal line 12a with the positive-side DC power supply current output from the positive side terminal 13a of the DC power supply 13 and outputs the high-frequency signal after the combination with the power supply current to the anode terminal 11a of the laser diode 11.

The first capacitor 16a is inserted in the first signal line 12a and has static capacitance Ci.

The first capacitor 16a is a variable capacitor capable of varying static capacitance Ci.

The first inductor 17a is inserted in the first power supply wiring 14a and has inductance $L_1$.

The first inductor 17a is inserted in the first power supply wiring 14a so that the high-frequency signal of the positive electrode side transmitted by the first signal line 12a does not flow toward the positive side terminal 13a of the DC power supply 13. For example, in a case where a signal transmitted by the first signal line 12a is a low-frequency signal, for example, a resistor may be inserted in the first power supply wiring 14a instead of the first inductor 17a.

A bias tee 15b includes a second capacitor 16b and a second inductor 17b and is connected with the cathode terminal 11b of the laser diode 11.

The bias tee 15b combines the high-frequency signal of the negative electrode side transmitted by the second signal line 12b with the negative-side DC power supply current flowing toward the negative side terminal 13b of the DC power supply 13 and outputs the high-frequency signal after the combination with the power supply current to the cathode terminal 11b of the laser diode 11.

The second capacitor 16b is inserted in the second signal line 12b and has static capacitance $C_2$.

The second capacitor 16b is a fixed capacitor of which static capacitance $C_2$ cannot be changed.

The second inductor 17b is inserted in the second power supply wiring 14b and has inductance $L_2$.

The second inductor 17b is inserted in the second power supply wiring 14b so that the high-frequency signal of the negative electrode side transmitted by the second signal line 12b does not flow toward the negative side terminal 13b of the DC power supply 13. In a case where a signal transmitted by the second signal line 12b is a low-frequency signal, for example, a resistor may be inserted in the second power supply wiring 14b instead of the second inductor 17b.

First parasitic capacitance 21 is parasitic capacitance $C_{14a-12a}$ formed between the first power supply wiring 14a and the first signal line 12a. Hereinafter, an area where the first parasitic capacitance 21 is formed between the first power supply wiring 14a and the first signal line 12a is referred to as the "portion forming the first parasitic capacitance 21".

Second parasitic capacitance 22 is parasitic capacitance $C_{14a-12b}$ formed between the first power supply wiring 14a and the second signal line 12b. Hereinafter, an area where the second parasitic capacitance 22 is formed between the first power supply wiring 14a and the second signal line 12b is referred to as the "portion forming the second parasitic capacitance 22".

Third parasitic capacitance 23 is parasitic capacitance $C_{14b-12a}$ formed between the second power supply wiring 14b and the first signal line 12a. Hereinafter, an area where the third parasitic capacitance 23 is formed between the second power supply wiring 14b and the first signal line 12a is referred to as the "portion forming the third parasitic capacitance 23".

Fourth parasitic capacitance 24 is parasitic capacitance $C_{14b - 12b}$ formed between the second power supply wiring 14b and the second signal line 12b. Hereinafter, an area where the fourth parasitic capacitance 24 is formed between the second power supply wiring 14b and the second signal line 12b is referred to as the "portion forming the fourth parasitic capacitance 24".

Note that separation is made by insulators between the first power supply wiring 14a and the first signal line 12a, between the first power supply wiring 14a and the second signal line 12b, between the second power supply wiring 14b and the first signal line 12a, and between the second power supply wiring 14b and the second signal line 12b, respectively. Parasitic capacitance is generated between a signal line and a power supply wiring separated by an insulator.

In the laser diode drive circuit 2 illustrated in FIG. 2, it is not that a capacitor as the first parasitic capacitance 21, a capacitor as the second parasitic capacitance 22, a capacitor as the third parasitic capacitance 23, or a capacitor as the fourth parasitic capacitance 24 is actually disposed, but the capacitors are illustrated for the purpose of explaining the parasitic capacitance.

Next, the operation of the laser diode drive circuit 2 illustrated in FIG. 2 will be described.

Of a differential high-frequency signal based on a data signal, the transmitter 1 outputs a high-frequency signal of the positive electrode side to the first input and output terminal 3a and outputs the high-frequency signal of the negative electrode side to the second input and output terminal 3b.

The high-frequency signal of the positive electrode side output from the transmitter 1 to the first input and output terminal 3a is transmitted by the first signal line 12a and reaches the bias tee 15a.

Likewise, the high-frequency signal of the negative electrode side output from the transmitter 1 to the second input and output terminal 3b is transmitted by the second signal line 12b and reaches the bias tee 15b.

The bias tee 15a combines the positive-side DC power supply current output from the positive side terminal 13a of the DC power supply 13 with the high-frequency signal of the positive electrode side transmitted by the first signal line 12a.

The bias tee 15a outputs the high-frequency signal of the positive electrode side after the combination with the power supply current to the anode terminal 11a of the laser diode 11.

The bias tee 15b combines the negative-side DC power supply current flowing toward the negative side terminal 13b of the DC power supply 13 with the high-frequency signal of the negative electrode side transmitted by the second signal line 12b.

The bias tee 15b outputs the high-frequency signal of the negative electrode side after the combination with the power supply current to the cathode terminal 11b of the laser diode 11.

Since the high-frequency signal of the positive electrode side after the combination with the power supply current is output from the bias tee 15a to the anode terminal 11a and the high-frequency signal of the negative electrode side after the combination with the power supply current is output from the bias tee 15b to the cathode terminal 11b, the potential of the anode terminal 11a is higher than the potential of the cathode terminal 11b.

The laser diode 11 emits light when the potential difference between the anode terminal 11a and the cathode terminal 11b is higher than the barrier voltage of the laser diode 11.

The laser diode 11 does not emit light when the potential difference between the anode terminal 11a and the cathode terminal 11b is less than or equal to the barrier voltage of the laser diode 11.

In the laser diode drive circuit 2 illustrated in FIG. 2, the first signal line 12a, the second signal line 12b, the first power supply wiring 14a, and the second power supply wiring 14b are each wired.

Therefore, the first parasitic capacitance 21 is formed between the first power supply wiring 14a and the first signal line 12a, and the second parasitic capacitance 22 is formed between the first power supply wiring 14a and the second signal line 12b.

Likewise, the third parasitic capacitance 23 is formed between the second power supply wiring 14b and the first signal line 12a, and the fourth parasitic capacitance 24 is formed between the second power supply wiring 14b and the second signal line 12b.

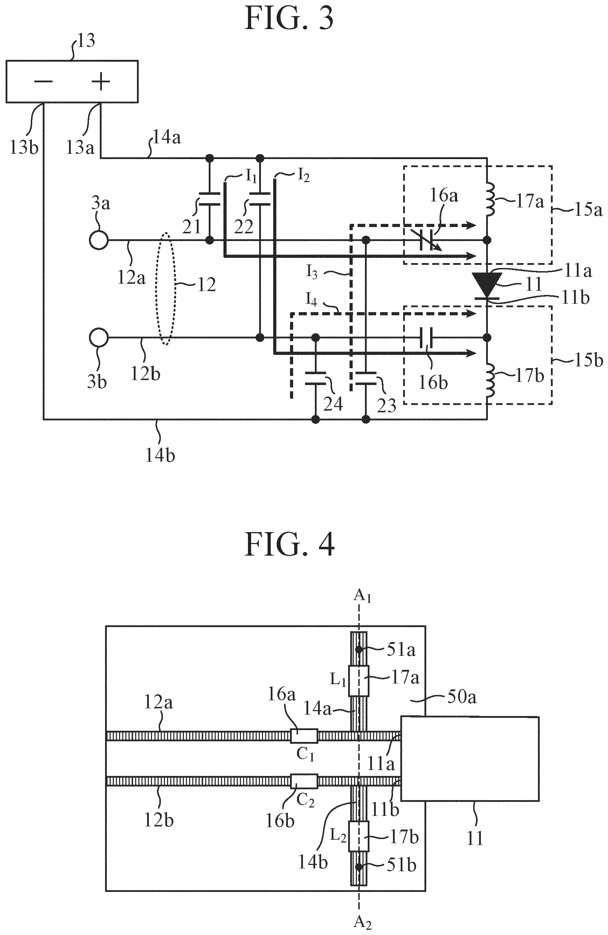

Since the first parasitic capacitance 21, the second parasitic capacitance 22, the third parasitic capacitance 23, and the fourth parasitic capacitance 24 are each formed, noise currents $I_1$ to $I_4$ flow in the differential line 12 as illustrated in FIG. 3.

FIG. 3 is an explanatory diagram illustrating paths of noise currents $I_1$ to $I_4$ flowing in the differential line 12.

Noise current $I_1$ is generated by being guided from the first power supply wiring 14a to the first signal line 12a via the portion forming the first parasitic capacitance 21. The path of noise current $I_1$ is as follows.

First power supply wiring 14a -> portion forming first parasitic capacitance 21 -> first signal line 12a -> anode terminal 11a of laser diode 11

Noise current $I_2$ is generated by being guided from the first power supply wiring 14a to the second signal line 12b via the portion forming the second parasitic capacitance 22. The path of noise current $I_2$ is as follows.

First power supply wiring 14a -> portion forming second parasitic capacitance 22 -> second signal line 12b -> cathode terminal 11b of laser diode 11

Noise current $I_3$ is generated by being guided from the second power supply wiring 14b to the first signal line 12a via the portion forming the third parasitic capacitance 23. The path of noise current $I_3$ is as follows.

Second power supply wiring 14b -> portion forming third parasitic capacitance 23 -> first signal line 12a -> anode terminal 11a of laser diode 11

Noise current $I_4$ is generated by being guided from the second power supply wiring 14b to the second signal line 12b via the portion forming the fourth parasitic capacitance 24. The path of noise current $I_4$ is as follows.

Second power supply wiring 14b -> portion forming fourth parasitic capacitance 24 -> second signal line 12b -> cathode terminal 11b of laser diode 11

For example, in a case where static capacitance Ci of the first capacitor 16a and static capacitance $C_2$ of the second capacitor 16b are the same, let us assume a case where the first parasitic capacitance 21 and the fourth parasitic capacitance 24 are different or a case where the second parasitic capacitance 22 and the third parasitic capacitance 23 are different.
Alternatively, let us assume a case where the first parasitic capacitance 21 and the fourth parasitic capacitance 24 are different and the second parasitic capacitance 22 and the third parasitic capacitance 23 are different in a case where static capacitance Ci of the first capacitor 16a and static capacitance $C_2$ of the second capacitor 16b are the same.
In these assumptions, there are cases where the potential difference between the anode terminal 11a and the cathode terminal 11b fluctuates when noise currents $I_1$ and $I_3$ flow through the first signal line 12a and reach the anode terminal 11a and noise currents $I_2$ and $I_4$ flow through the second signal line 12b and reach the cathode terminal 11b.
In a case where the potential difference between the anode terminal 11a and the cathode terminal 11b fluctuates associated with the generation of noise currents $I_1$ to $I_4$, the laser diode 11 may erroneously emit light or erroneously go off.
Here, let us assume that the combined capacitance of static capacitance Ci of the first capacitor 16a and the first parasitic capacitance 21 is $GC_{1, 14a - 12a}$ (see Equation 1 below) and that the combined capacitance of static capacitance $C_2$ of the second capacitor 16b and the fourth parasitic capacitance 24 is $GC_{2, 14b - 12b}$ (see Equation 2 below).
Likewise, let us assume that the combined capacitance of static capacitance Ci of the first capacitor 16a and the third parasitic capacitance 23 is $GC_{1, 14b - 12a}$ (see Equation 3 below) and that the combined capacitance of static capacitance $C_2$ of the second capacitor 16b and the second parasitic capacitance 22 is $GC_{2, 14a - 12b}$ (see Equation 4 below).

$$GC_{1,14a-12a} = \frac{C_1 \times C_{14a-12a}}{C_1 + C_{14a-12a}} \qquad (1)$$

$$GC_{2,14b-12b} = \frac{C_2 \times C_{14b-12b}}{C_2 + C_{14b-12b}} \qquad (2)$$

$$GC_{1,14b-12a} = \frac{C_1 \times C_{14b-12a}}{C_1 + C_{14b-12a}} \qquad (3)$$

$$GC_{2,14a-12b} = \frac{C_2 \times C_{14a-12b}}{C_2 + C_{14a-12b}} \qquad (4)$$

In a case where combined capacitance $GC_{1, 14a - 12a}$ and combined capacitance $GC_{2, 14b - 12b}$ are different or combined capacitance $GC_{1, 14b - 12a}$ and combined capacitance $GC_{2, 14a - 12b}$ are different, there may be a difference between the sum of noise current $I_1$ and noise current $I_3$ and the sum of noise current $I_2$ and noise current $I_4$.

In addition, in a case where combined capacitance $GC_{1, 14a - 12a}$ and combined capacitance $GC_{2, 14b - 12b}$ are different and combined capacitance $GC_{1, 14b - 12a}$ and combined capacitance $GC_{2, 14a - 12b}$ are different, there may be a difference between the sum of noise current $I_1$ and noise current $I_3$ and the sum of noise current $I_2$ and noise current $I_4$.

When there is a difference between the sum of noise current $I_1$ and noise current $I_3$ and the sum of noise current $I_2$ and noise current $I_4$, the potential difference between the anode terminal 11a and the cathode terminal 11b may fluctuate.

On the other hand, when combined capacitance $GC_{1, 14a - 12a}$ and combined capacitance $GC_{2, 14b - 12b}$ are equal and combined capacitance $GC_{1, 14b - 12a}$ and combined capacitance $GC_{2, 14a - 12b}$ are equal, the sum of noise current $I_1$ and noise current $I_3$ and the sum of noise current $I_2$ and noise current $I_4$ are equal. When the sum of noise current $I_1$ and noise current $I_3$ and the sum of noise current $I_2$ and noise current $I_4$ are equal, the potential difference between the anode terminal 11a and the cathode terminal 11b does not fluctuate even if noise currents $I_1$ to $I_4$ are generated. When the potential difference between the anode terminal 11a and the cathode terminal 11b does not fluctuate, the laser diode 11 does not erroneously emit light nor erroneously goes off.

In the laser diode drive circuit 2 illustrated in FIG. 2, static capacitance Ci of the first capacitor 16a, which is a variable capacitor, is adjusted so that combined capacitance $GC_{1, 14a - 12a}$ and combined capacitance $GC_{2, 14b - 12b}$ are equal and that combined capacitance $GC_{1, 14b - 12a}$ and combined capacitance $GC_{2, 14a - 12b}$ are equal.

Hereinafter, the configuration of a case where the laser diode drive circuit 2 illustrated in FIG. 2 is mounted on a substrate 50 having a two-layer structure will be described.

FIG. 4 is a diagram illustrating the pattern of a first layer 50a of the substrate 50 on which the laser diode drive circuit 2 illustrated in FIG. 2 is mounted.

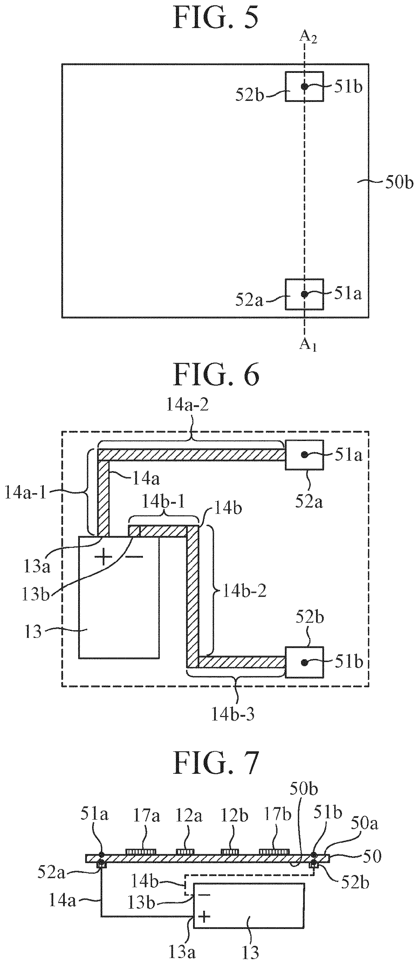

FIG. 5 is a diagram illustrating the pattern of a second layer 50b of the substrate 50 on which the laser diode drive circuit 2 illustrated in FIG. 2 is mounted.

FIG. 6 is a diagram illustrating the arrangement relationship between the DC power supply 13 provided outside the substrate 50 and portions of the first power supply wiring 14a and the second power supply wiring 14b that are wired outside the substrate 50.

FIG. 7 is a cross-sectional view taken along line $A_1 - A_2$ of the laser diode drive circuit 2 illustrated in FIGS. 4 and 5.

In FIGS. 4 to 7, the first capacitor 16a, the second capacitor 16b, the first inductor 17a, and the second inductor 17b are mounted on the first layer 50a of the substrate 50.

The first signal line 12a, the second signal line 12b, a part of the first power supply wiring 14a, and a part of the second power supply wiring 14b are also wired on the first layer 50a of the substrate 50.

In addition, a part of the laser diode 11 is mounted on the first layer 50a of the substrate 50.

The first power supply wiring 14a wired on the first layer 50a of the substrate 50 is connected with one end of a via 51a, and the other end of the via 51a is connected with a conductor 52a wired on the second layer 50b of the substrate 50.

The second power supply wiring 14b wired on the first layer 50a of the substrate 50 is connected with one end of a via 51b, and the other end of the via 51b is connected with a conductor 52b wired on the second layer 50b of the substrate 50.

First power supply wiring 14a-1 and 14a-2 are portions of the first power supply wiring 14a that are wired outside the substrate 50.

The first power supply wiring 14a-1 has one end connected with the positive side terminal 13a of the DC power supply 13 and the other end connected with one end of the first power supply wiring 14a-2.

The first power supply wiring 14a-2 has the one end connected with the other end of the first power supply wiring 14a-1 and the other end connected with the conductor 52a.

The second power supply wiring 14b-1, 14b-2, and 14b-3 are portions of the second power supply wiring 14b that are wired outside the substrate 50.

The second power supply wiring 14b-1 has one end connected with the negative side terminal 13b of the DC power supply 13 and the other end connected with one end of the second power supply wiring 14b-2.

The second power supply wiring 14b-2 has one end connected with the other end of the second power supply wiring 14b-1 and the other end connected with one end of the second power supply wiring 14b-3.

The second power supply wiring 14b-3 has the one end connected with the other end of the second power supply wiring 14b-2 and the other end connected with the conductor 52b.

In the arrangement example of FIG. 6, the first power supply wiring 14a-2 is disposed parallel to each of the first signal line 12a and the second signal line 12b, and the first power supply wiring 14a-2 is electrically coupled with each of the first signal line 12a and the second signal line 12b.

Since the distance between the first power supply wiring 14a-2 and the first signal line 12a is shorter than the distance between the first power supply wiring 14a-2 and the second signal line 12b, the amount of coupling between the first power supply wiring 14a-2 and the first signal line 12a is larger than the amount of coupling between the first power supply wiring 14a-2 and the second signal line 12b.

In the arrangement example of FIG. 6, the second power supply wiring 14b-1 is disposed parallel to each of the first signal line 12a and the second signal line 12b, and the second power supply wiring 14b-1 is electrically coupled with each of the first signal line 12a and the second signal line 12b.

Since the distance between the second power supply wiring 14b-1 and the first signal line 12a is shorter than the distance between the second power supply wiring 14b-1 and the second signal line 12b, the amount of coupling between the second power supply wiring 14b-1 and the first signal line 12a is larger than the amount of coupling between the second power supply wiring 14b-1 and the second signal line 12b.

In the arrangement example of FIG. 6, the second power supply wiring 14b-3 is disposed parallel to each of the first signal line 12a and the second signal line 12b, and the second power supply wiring 14b-3 is electrically coupled with each of the first signal line 12a and the second signal line 12b.

Since the distance between the second power supply wiring 14b-3 and the first signal line 12a is longer than the distance between the second power supply wiring 14b-3 and the second signal line 12b, the amount of coupling between the second power supply wiring 14b-3 and the first signal line 12a is smaller than the amount of coupling between the second power supply wiring 14b-3 and the second signal line 12b.

Note that, since the second power supply wiring 14b-3 has a longer distance from each of the first signal line 12a and the second signal line 12b than the second power supply wiring 14b-1 has, the amount of coupling between the second power supply wiring 14b-3 and the first signal line 12a is smaller than the amount of coupling between the second power supply wiring 14b-1 and the first signal line 12a. Likewise, the amount of coupling between the second power supply wiring 14b-3 and the second signal line 12b is smaller than the amount of coupling between the second power supply wiring 14b-1 and the second signal line 12b. Here, for the sake of simplicity of the explanation, the line length of the second power supply wiring 14b-1 and the line length of the second power supply wiring 14b-3 are neglected.

Therefore, the amount of coupling between power supply wiring obtained by adding the second power supply wiring 14b-1 and the second power supply wiring 14b-3 and the first signal line 12a is larger than the amount of coupling between the power supply wiring obtained by adding the second power supply wiring 14b-1 and the second power supply wiring 14b-3 and the second signal line 12b.

In FIG. 6, the arrangement example is illustrated in which the average distance between the power supply wiring obtained by adding the second power supply wiring 14b-1 and the second power supply wiring 14b-3 and the second signal line 12b is shorter than the distance between the first power supply wiring 14a-2 and the first signal line 12a.

In the arrangement example of FIG. 6, the amount of coupling between the power supply wiring obtained by adding the second power supply wiring 14b-1 and the second power supply wiring 14b-3 and the second signal line 12b is larger than the amount of coupling between the first power supply wiring 14a-2 and the first signal line 12a.

From the above, in the arrangement example of FIG. 6, the first parasitic capacitance 21 formed between the first power supply wiring 14a and the first signal line 12a is different from the fourth parasitic capacitance 24 formed between the second power supply wiring 14b and the second signal line 12b.

Likewise, the third parasitic capacitance 23 formed between the second power supply wiring 14b and the first signal line 12a is different from the second parasitic capacitance 22 formed between the first power supply wiring 14a and the second signal line 12b.

Therefore, when static capacitance Ci of the first capacitor 16a and static capacitance $C_2$ of the second capacitor 16b are the same, combined capacitance $GC_{1, 14a-12a}$ and combined capacitance $GC_{2, 14b-12b}$ are different and combined capacitance $GC_{1, 14b-12a}$ and combined capacitance $GC_{2, 14a-12b}$ are different.

In the laser diode drive circuit 2 illustrated in FIG. 2, static capacitance Ci of the first capacitor 16a, which is a variable capacitor, is adjusted so that combined capacitance $GC_{1, 14a-12a}$ and combined capacitance $GC_{2, 14b-12b}$ are equal and that combined capacitance $GC_{1, 14b-12a}$ and combined capacitance $GC_{2, 14a-12b}$ are equal.

In the laser diode drive circuit 2 illustrated in FIG. 2, since static capacitance Ci of the first capacitor 16a is adjusted, the potential difference between the anode terminal 11a and the cathode terminal 11b does not fluctuate even when noise currents $I_1$ to $I_4$ are generated.

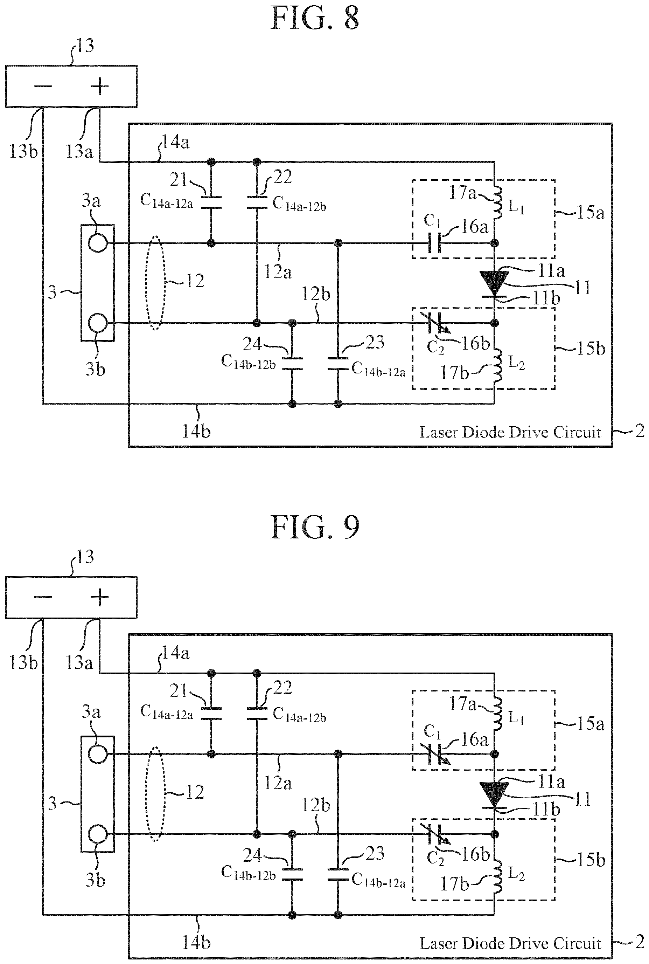

In the laser diode drive circuit 2 illustrated in FIG. 2, the first capacitor 16a is a variable capacitor, and the second capacitor 16b is a fixed capacitor. However, this is merely an example, and, for example, as illustrated in FIG. 8, the first capacitor 16a may be a fixed capacitor, and the second capacitor 16b may be a variable capacitor.

FIG. 8 is a configuration diagram illustrating another laser diode drive circuit 2 according to the first embodiment.

It is also possible to make combined capacitance $GC_{1, 14a-12a}$ and combined capacitance $GC_{2, 14b-12b}$ equal to each other and combined capacitance $GC_{1, 14b-12a}$ and combined capacitance $GC_{2, 14a-12b}$ equal to each other by adjusting static capacitance $C_2$ of the second capacitor 16b which is a variable capacitor.

Therefore, also by adjusting static capacitance $C_2$ of the second capacitor 16b, it is possible to prevent both of erroneous emission of light and erroneous extinction of light of the laser diode 11 as in the laser diode drive circuit 2 illustrated in FIG. 2.

Alternatively, as illustrated in FIG. 9, the first capacitor 16a and the second capacitor 16b may be both variable capacitors.

FIG. 9 is a configuration diagram illustrating another laser diode drive circuit 2 according to the first embodiment.

Also by adjusting each of static capacitance Ci of the first capacitor 16a and static capacitance $C_2$ of the second capacitor 16b, it is possible to make combined capacitance $GC_{1, 14a - 12a}$ and combined capacitance $GC_{2, 14b - 12b}$ equal to each other and combined capacitance $GC_{1, 14b - 12a}$ and combined capacitance $GC_{2, 14a - 12b}$ equal to each other.

Therefore, also by adjusting each of static capacitance Ci of the first capacitor 16a and static capacitance $C_2$ of the second capacitor 16b, it is possible to prevent both of erroneous emission of light and erroneous extinction of light of the laser diode 11 as in the laser diode drive circuit 2 illustrated in FIG. 2.

In a case where static capacitance Ci of the first capacitor 16a and static capacitance $C_2$ of the second capacitor 16b are each adjusted, the adjustment range of the combined capacitance is wider than that in the case where only static capacitance Ci of the first capacitor 16a is adjusted.

Specifically, in a case where the difference between combined capacitance $GC_{1, 14a - 12a}$ and combined capacitance $GC_{2, 14b - 12b}$ or the difference between combined capacitance $GC_{1, 14b - 12a}$ and combined capacitance $GC_{2, 14a - 12b}$ is large, there are cases where it is not possible to make combined capacitance $GC_{1, 14a - 12a}$ and combined capacitance $GC_{2, 14b - 12b}$ equal to each other and also to make combined capacitance $GC_{1, 14b - 12a}$ and combined capacitance $GC_{2, 14a - 12b}$ equal to each other if only static capacitance Ci of the first capacitor 16a is adjusted.

However, even in a case where the difference is large, by adjusting each of static capacitance Ci of the first capacitor 16a and static capacitance $C_2$ of the second capacitor 16b, it is possible to make combined capacitance $GC_{1, 14a - 12a}$ and combined capacitance $GC_{2, 14b - 12b}$ equal to each other and also to make combined capacitance $GC_{1, 14b - 12a}$ and combined capacitance $GC_{2, 14a - 12b}$ equal to each other.

In the above-described first embodiment, the laser diode drive circuit 2 is configured so that at least one of the first capacitor 16a and the second capacitor 16b is a variable capacitor. Therefore, the laser diode drive circuit 2 is capable of preventing both of erroneous emission of light and erroneous extinction of light of the laser diode 11 even when noise is induced to the differential line 12 from the first power supply wiring 14a and the second power supply wiring 14b via the portions forming parasitic capacitance.

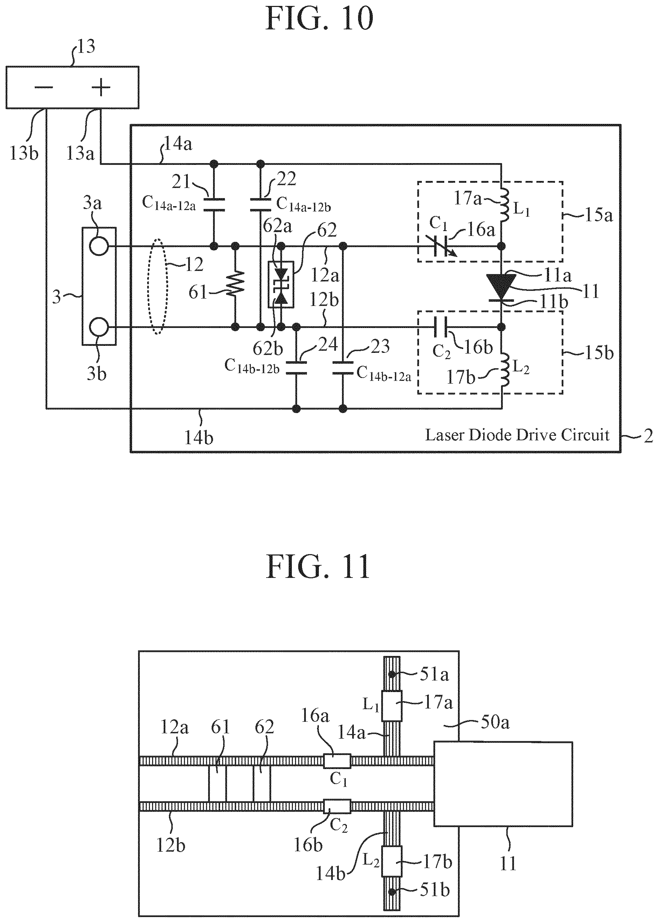

FIG. 10 is a configuration diagram illustrating another laser diode drive circuit 2 according to the first embodiment.

FIG. 11 is a diagram illustrating the pattern of a first layer 50a of a substrate 50 on which the laser diode drive circuit 2 illustrated in FIG. 10 is mounted.

In FIGS. 10 and 11, the same symbols as those in FIGS. 2 and 4 represent the same or corresponding parts.

A resistor 61 has one end connected with the first signal line 12a and the other end connected with the second signal line 12b.

A protection circuit 62 has one end connected with the first signal line 12a and the other end connected with the second signal line 12b.

The protection circuit 62 is implemented by, for example, a Zener diode 62a and a Zener diode 62b.

In the Zener diode 62a, its anode terminal is connected with the first signal line 12a, and its cathode terminal is connected with a cathode terminal of the Zener diode 62b.

In the Zener diode 62b, its anode terminal is connected with the second signal line 12b, and its cathode terminal is connected with the cathode terminal of the Zener diode 62a.

The resistor 61 is used for matching of the impedance of the first signal line 12a with the impedance of the second signal line 12b.

The protection circuit 62 is used to prevent an excessive noise current $I_1$ flowing through the first signal line 12a from entering the second signal line 12b, and the protection circuit 62 is used to prevent an excessive noise current $I_3$ flowing through the first signal line 12a from entering the second signal line 12b.

The protection circuit 62 is also used to prevent an excessive noise current $I_2$ flowing through the second signal line 12b from entering the first signal line 12a, and the protection circuit 62 is used to prevent an excessive noise current $I_4$ flowing through the second signal line 12b from entering the first signal line 12a.

Like the laser diode drive circuit 2 illustrated in FIG. 2, the laser diode drive circuit 2 illustrated in FIG. 10 is capable of preventing both erroneous emission of light and erroneous extinction of light of the laser diode. Furthermore, since the laser diode drive circuit 2 illustrated in FIG. 10 includes the resistor 61, the impedance of the first signal line 12a can be matched with the impedance of the second signal line 12b.

Since the laser diode drive circuit 2 illustrated in FIG. 10 includes the protection circuit 62, it is possible to prevent the excessive noise currents $I_1$ and $I_3$ flowing through the first signal line 12a from entering the second signal line 12b and to prevent the excessive noise currents $I_2$ and $I_4$ flowing through the second signal line 12b from entering the first signal line 12a.

Second Embodiment

In the laser diode drive circuit 2 of the first embodiment, the first inductor 17a is inserted in the first power supply wiring 14a.

In a second embodiment, a laser diode drive circuit 2 in which a first inductor 17a and a first variable inductor 71a are inserted in first power supply wiring 14a will be described.

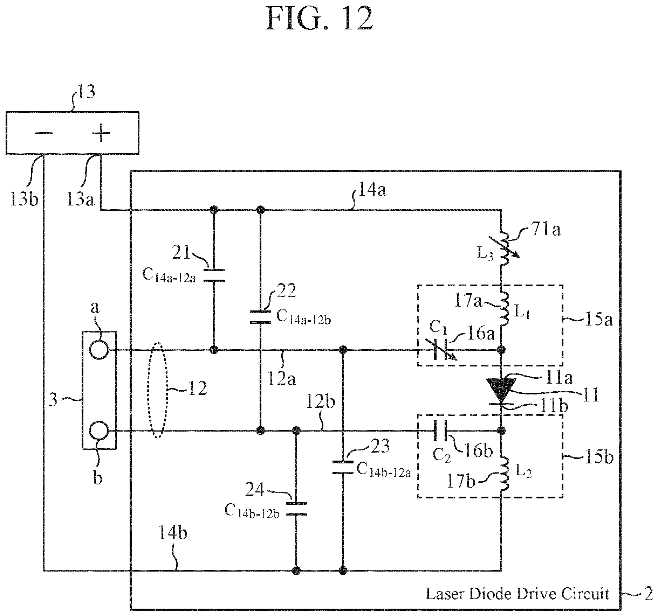

FIG. 12 is a configuration diagram illustrating the laser diode drive circuit 2 according to the second embodiment. In FIG. 12, the same symbols as those in FIG. 2 represent the same or corresponding parts, and thus description thereof is omitted.

The first variable inductor 71a is inserted in the first power supply wiring 14a.

The first variable inductor 71a has inductance $L_3$, and inductance $L_3$ can be adjusted so that a winding error of each coil in the first inductor 17a and the second inductor 17b is compensated.

In the first variable inductor 71a, inductance $L_3$ changes, for example, by adjusting a relative position between the core and the winding and thereby adjusting magnetic permeability.

In the laser diode drive circuit 2 illustrated in FIG. 12, the first variable inductor 71a has one end connected with the positive side terminal 13a of the DC power supply 13 and the other end connected with one end of the first inductor 17a. However, this is merely an example, and the one end of the first variable inductor 71a may be connected with the other end of the first inductor 17a, and the other end of the first variable inductor 71a may be connected with the anode terminal 11a of the laser diode 11.

Next, the operation of the laser diode drive circuit 2 illustrated in FIG. 12 will be described.

There are cases where the coil included the first inductor 17a has a winding error as a manufacturing error.

The coil included the second inductor 17b may also have a winding error as a manufacturing error in some cases.

Therefore, there are cases where inductance $L_1$ of the first inductor 17a is different from the design inductance and inductance $L_2$ of the second inductor 17b is different from the design inductance.

When inductances $L_1$ and $L_2$ are different from the design inductance, the laser diode 11 may not emit light in accordance with a differential high-frequency signal based on a data signal output from a transmitter 1.

For example, let us assume that, in a case where the design inductance of the first inductor 17a and the design inductance of the second inductor 17b are the same, each coil in the first inductor 17a and the second inductor 17b has a winding error.

Let us further assume that inductance $L_1$ of the first inductor 17a is smaller than inductance $L_2$ of the second inductor 17b ($Li < L_2$) since each of the coils has a winding error.

In the laser diode drive circuit 2 illustrated in FIG. 12, inductance $L_3$ of the first variable inductor 71a is adjusted so that the sum of inductance $L_1$ and inductance $L_3$ of the first variable inductor 71a ($Li + L_3$) is equal to inductance $L_2$.

By adjusting inductance $L_3$ of the first variable inductor 71a, a winding error of each of the coils in the first inductor 17a and the second inductor 17b is compensated.

For example, let us assume that, in a case where the design inductance of the first inductor 17a is smaller than the design inductance of the second inductor 17b by $\Delta L_{1,2}$, each of the coils in the first inductor 17a and the second inductor 17b has a winding error.

Let us further assume that inductance $L_1$ is smaller than inductance $L_2$ and that the difference between inductance $L_1$ and inductance $L_2$ ($L_2 - L_1$) is larger than $\Delta L_{1,2}$ ($L_2 - L_1 > \Delta L_{1,2}$) since each of the coils has a winding error.

In the laser diode drive circuit 2 illustrated in FIG. 12, inductance $L_3$ of the first variable inductor 71a is adjusted so that the difference between the sum ($Li + L_3$) of inductance $L_1$ and inductance $L_3$ and inductance $L_2$ ($L_2 - (Li + L_3)$) is equal to $\Delta L_{1,2}$.

By adjusting inductance $L_3$ of the first variable inductor 71a, a winding error of each of the coils in the first inductor 17a and the second inductor 17b is compensated.

In the second embodiment described above, the laser diode drive circuit 2 includes the first variable inductor 71a inserted in the first power supply wiring 14a, and the first variable inductor 71a can be adjusted so that a winding error of each of the coils in the first inductor 17a and the second inductor 17b is compensated. Therefore, the laser diode drive circuit 2 is capable of preventing both erroneous emission of light and erroneous extinction of light of the laser diode even if each of the coils in the first inductor 17a and the second inductor 17b has a winding error.

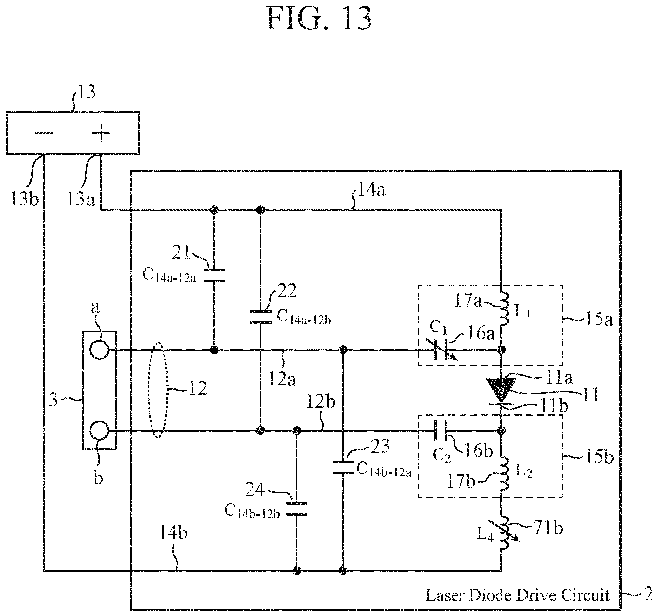

In the laser diode drive circuit 2 illustrated in FIG. 12, the first variable inductor 71a is inserted in the first power supply wiring 14a. However, this is merely an example, and, for example, a second variable inductor 71b may be inserted in the second power supply wiring 14b in the laser diode drive circuit 2 as illustrated in FIG. 13.

FIG. 13 is a configuration diagram illustrating another laser diode drive circuit 2 according to the second embodiment.

A second variable inductor 71b is inserted in the second power supply wiring 14b.

The second variable inductor 71b has inductance $L_4$, and inductance $L_4$ can be adjusted so that a winding error of each of the coils in the first inductor 17a and the second inductor 17b is compensated.

In the second variable inductor 71b, inductance $L_4$ changes, for example, by adjusting a relative position between the core and the winding and thereby adjusting magnetic permeability.

In the laser diode drive circuit 2 illustrated in FIG. 13, the second variable inductor 71b has one end connected with the negative side terminal 13b of the DC power supply 13 and the other end connected with one end of the second inductor 17b. However, this is merely an example, and the one end of the second variable inductor 71b may be connected with the other end of the second inductor 17b, and the other end of the second variable inductor 71b may be connected with the cathode terminal 11b of the laser diode 11.

For example, let us assume that, in a case where the design inductance of the first inductor 17a and the design inductance of the second inductor 17b are the same, each coil in the first inductor 17a and the second inductor 17b has a winding error.

Let us further assume that inductance $L_1$ of the first inductor 17a is larger than inductance $L_2$ of the second inductor 17b (Li > $L_2$) since each of the coils has a winding error.

In the laser diode drive circuit 2 illustrated in FIG. 13, inductance $L_4$ of the second variable inductor 71b is adjusted so that the sum of inductance $L_2$ and inductance $L_4$ of the second variable inductor 71b ($L_2 + L_4$) is equal to inductance $L_1$.

By adjusting inductance $L_4$ of the second variable inductor 71b, a winding error of each of the coils in the first inductor 17a and the second inductor 17b is compensated.

For example, let us assume that, in a case where the design inductance of the first inductor 17a is larger than the design inductance of the second inductor 17b by $\Delta L_{1,2}$, each of the coils in the first inductor 17a and the second inductor 17b has a winding error.

Let us further assume that inductance $L_1$ is larger than inductance $L_2$ and that the difference between inductance $L_1$ and inductance $L_2$ (Li - $L_2$) is larger than $\Delta L_{1,2}$ (Li - $L_2 > \Delta L_{1,2}$) since each of the coils has a winding error.

In the laser diode drive circuit 2 illustrated in FIG. 13, inductance $L_4$ of the second variable inductor 71b is adjusted so that the difference between the sum ($L_2 + L_4$) of inductance $L_2$ and inductance $L_4$ and inductance $L_1$ (Li - ($L_2 + L_4$)) is equal to $\Delta L_{1,2}$.

By adjusting inductance $L_4$ of the second variable inductor 71b, a winding error of each of the coils in the first inductor 17a and the second inductor 17b is compensated.

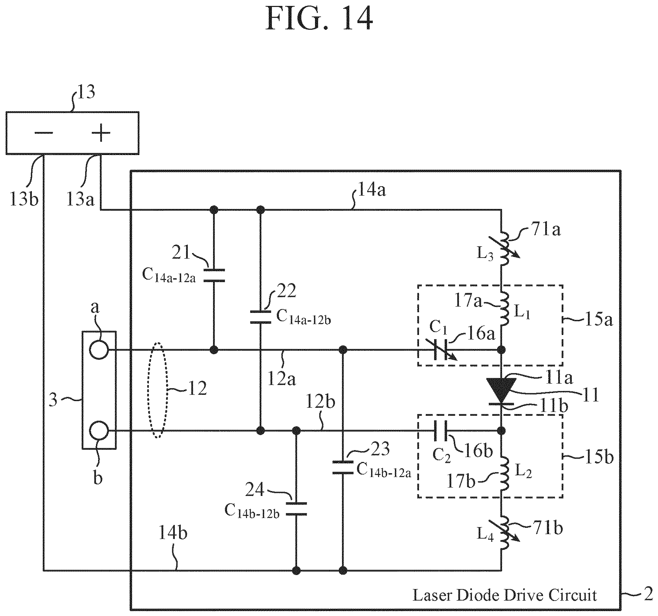

In the laser diode drive circuit 2 illustrated in FIG. 12, the first variable inductor 71a is inserted in the first power supply wiring 14a. However, this is merely an example, and, for example, as illustrated in FIG. 14, the first variable inductor 71a may be inserted in the first power supply wiring 14a, and the second variable inductor 71b may be inserted in the second power supply wiring 14b in the laser diode drive circuit 2.

FIG. 14 is a configuration diagram illustrating another laser diode drive circuit 2 according to the second embodiment.

Since the laser diode drive circuit 2 includes the first variable inductor 71a and the second variable inductor 71b, it is possible to compensate for a larger winding error than in the laser diode drive circuit 2 illustrated in FIG. 12.

In the laser diode drive circuit 2 illustrated in FIG. 12, the first variable inductor 71a is inserted in the first power supply wiring 14a.

Instead of inserting the first variable inductor 71a in the first power supply wiring 14a, a variable inductor may be used as the first inductor 17a in the laser diode drive circuit 2.

In a case where the laser diode drive circuit 2 uses a variable inductor as the first inductor 17a, inductance $L_1$ of the first inductor 17a is adjusted so that a winding error of each of the coils in the first inductor 17a and the second inductor 17b is compensated. Therefore, the winding error of each of the coils can be compensated as in the case where the first variable inductor 71a is inserted in the first power supply wiring 14a.

Alternatively, instead of the first variable inductor 71a inserted in the first power supply wiring 14a, a variable inductor may be used as the second inductor 17b in the laser diode drive circuit 2. Further alternatively, instead of the first variable inductor 71a inserted in the first power supply wiring 14a, a variable inductor may be used as the first inductor 17a, and a variable inductor may be used as the second inductor 17b in the laser diode drive circuit 2.

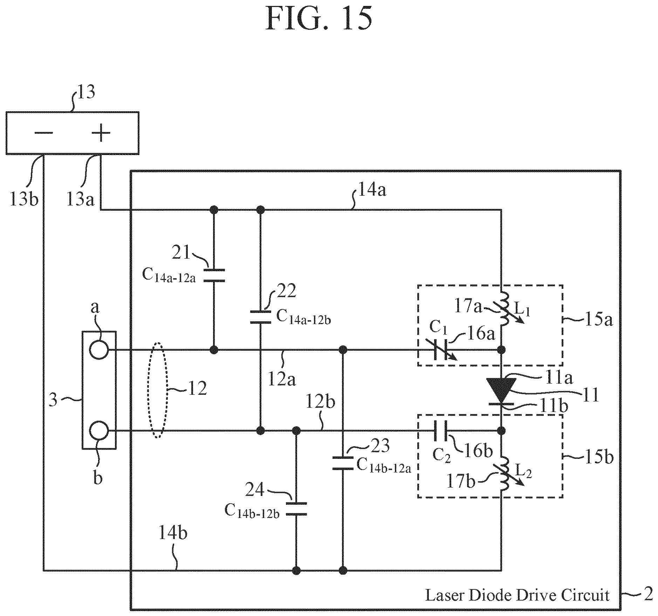

FIG. 15 is a configuration diagram illustrating another laser diode drive circuit 2 according to the second embodiment.

In the laser diode drive circuit 2 illustrated in FIG. 15, a first inductor 17a and a second inductor 17b are both variable inductors.

In the laser diode drive circuit 2 illustrated in FIGS. 12 to 15, the first capacitor 16a is a variable capacitor, and the second capacitor 16b is a fixed capacitor. However, this is merely an example, and the first capacitor 16a may be a fixed capacitor, and the second capacitor 16b may be a variable capacitor.

Alternatively, both the first capacitor 16a and the second capacitor 16b may be variable capacitors.

Note that the present invention may include a flexible combination of the embodiments, a modification of any component of the embodiments, or an omission of any component in the embodiments within the scope of the present invention.

## INDUSTRIAL APPLICABILITY

The present invention is suitable for a laser diode drive circuit including a laser diode and a communication device.

## REFERENCE SIGNS LIST

1: transmitter, 2: laser diode drive circuit, 3: differential input and output terminal, 3a: first input and output terminal, 3b: second input and output terminal, 11: laser diode, 11a: anode terminal, 11b: cathode terminal, 12: differential line, 12a: first signal line, 12b: second signal line, 13: DC power supply, 13a: positive side terminal, 13b: negative side terminal, 14a, 14a-1, 14a-2: first power supply wiring, 14b, 14b-1, 14b-2, 14b-3: second power supply wiring, 15a, 15b: bias tee, 16a: first capacitor, 16b: second capacitor, 17a: first inductor, 17b: second inductor, 21: first parasitic capacitance, 22: second parasitic capacitance, 23: third parasitic capacitance, 24: fourth parasitic capacitance, 50: substrate, 50a: first layer, 50b: second layer, 51a: via, 51b: via, 52a: conductor, 52b: conductor, 61: resistor, 62: protection circuit, 62a, 62b: Zener diode, 71a: first variable inductor, 71b: second variable inductor

## Claims

1. A laser diode drive circuit comprising:

   a laser diode;
   a differential line including a first signal line having a first end connected with an anode terminal of the laser diode and a second signal line having a first end connected with a cathode terminal of the laser diode;
   first power supply wiring having a first end connected with a positive side terminal of a direct current power supply and a second end connected with the anode terminal;
   second power supply wiring having a first end connected with a negative side terminal of the direct current power supply and a second end connected with the cathode terminal;
   a first capacitor inserted in the first signal line; and
   a second capacitor inserted in the second signal line,
   wherein at least one of the first capacitor and the second capacitor is a variable capacitor.

2. The laser diode drive circuit according to claim 1,

   wherein parasitic capacitance formed between the first power supply wiring and the first signal line is first parasitic capacitance,
   parasitic capacitance formed between the first power supply wiring and the second signal line is second parasitic capacitance,
   parasitic capacitance formed between the second power supply wiring and the first signal line is third parasitic capacitance,
   parasitic capacitance formed between the second power supply wiring and the second signal line is fourth parasitic capacitance, and
   the variable capacitor is adjustable so that combined capacitance of static capacitance of the first capacitor and the first parasitic capacitance is equal to combined capacitance of static capacitance of the second capacitor and the fourth parasitic capacitance and that combined capacitance of static capacitance of the first capacitor and the third parasitic capacitance is equal to combined capacitance of static capacitance of the second capacitor and the second parasitic capacitance.

3. The laser diode drive circuit according to claim 1, further comprising:

   a first inductor inserted in the first power supply wiring; and
   a second inductor inserted in the second power supply wiring.

4. The laser diode drive circuit according to claim 3, further comprising:

   a first variable inductor inserted in the first power supply wiring,
   wherein the first variable inductor is adjustable so that a winding error of each of coils in the first inductor and the second inductor is compensated.

**5.** The laser diode drive circuit according to claim 3, further comprising:

a second variable inductor inserted in the second power supply wiring,
wherein the second variable inductor is adjustable so that a winding error of each of coils in the first inductor and the second inductor is compensated.

**6.** The laser diode drive circuit according to claim 3, further comprising:

a first variable inductor inserted in the first power supply wiring; and
a second variable inductor inserted in the second power supply wiring,
wherein inductance of the first variable inductor and inductance of the second variable inductor are each adjustable so that a winding error of each of coils in the first inductor and the second inductor is compensated.

**7.** The laser diode drive circuit according to claim 3,

wherein at least one of the first inductor and the second inductor is a variable inductor, and
the variable inductor is adjustable so that a winding error of each of coils in the first inductor and the second inductor is compensated.

**8.** A communication device comprising a laser diode drive circuit,
wherein the laser diode drive circuit includes:

a laser diode;
a differential line including a first signal line having a first end connected with an anode terminal of the laser diode and a second signal line having a first end connected with a cathode terminal of the laser diode;
first power supply wiring having a first end connected with a positive side terminal of a direct current power supply and a second end connected with the anode terminal;
second power supply wiring having a first end connected with a negative side terminal of the direct current power supply and a second end connected with the cathode terminal;
a first capacitor inserted in the first signal line; and
a second capacitor inserted in the second signal line, and
at least one of the first capacitor and the second capacitor is a variable capacitor.

# FIG. 1

# FIG. 2

# FIG. 3

# FIG. 4

# FIG. 5

# FIG. 6

# FIG. 7

# FIG. 8

# FIG. 9

# FIG. 10

# FIG. 11

# FIG. 12

# FIG. 13

# FIG. 14

# FIG. 15

Laser Diode Drive Circuit ~2

## INTERNATIONAL SEARCH REPORT

International application No.

PCT/JP2019/003856

### A. CLASSIFICATION OF SUBJECT MATTER
Int. Cl. H04B10/50(2013.01)i, H01S5/042(2006.01)i

According to International Patent Classification (IPC) or to both national classification and IPC

### B. FIELDS SEARCHED

Minimum documentation searched (classification system followed by classification symbols)
Int. Cl. H04B10/50, H01S5/042

Documentation searched other than minimum documentation to the extent that such documents are included in the fields searched

Published examined utility model applications of Japan     1922-1996
Published unexamined utility model applications of Japan   1971-2019
Registered utility model specifications of Japan           1996-2019
Published registered utility model applications of Japan   1994-2019

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2015/107729 A1 (SUMITOMO ELECTRIC INDUSTRIES, LTD.) 23 July 2015, entire text & US 2016/0329968 A1, entire text | 1-8 |
| A | JP 2005-252783 A (MITSUBISHI ELECTRIC CORP.) 15 September 2005, entire text (Family: none) | 1-8 |
| A | JP 2008-311524 A (SUMITOMO ELECTRIC INDUSTRIES, LTD.) 25 December 2008, entire text (Family: none) | 1-8 |
| A | JP 2006-261461 A (RICOH CO., LTD.) 28 September 2006, entire text (Family: none) | 1-8 |

☒ Further documents are listed in the continuation of Box C.　　☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 26.03.2019 | 02.04.2019 |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**INTERNATIONAL SEARCH REPORT**

| International application No. |
|---|
| PCT/JP2019/003856 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 1-281782 A (HAMAMATSU PHOTONICS KABUSHIKI KAISHA) 13 November 1989, entire text & GB 2219149 A, entire text | 1-8 |

Form PCT/ISA/210 (continuation of second sheet) (January 2015)

**EP 3 905 550 A1**

**REFERENCES CITED IN THE DESCRIPTION**

**Patent documents cited in the description**

- JP 2005252783 A